# EUROPEAN PATENT APPLICATION

(11) **EP 2 256 791 A1**
(43) Date of publication of application: **01.12.2010**
(21) Application number: 09715579.0
(22) Date of filing: 27.01.2009
(51) Int. Cl.: H01L 21/203, C23C 14/35

(54) **METHOD FOR OBTAINING FILMS OF SEMICONDUCTOR MATERIALS INCLUDING AN INTERMEDIATE BAND**

(30) Priority: 28.02.2008 ES 200800571
(71) Applicant: Universidad Politécnica De Madrid, 28040 Madrid (ES); Universitat Politècnica de Catalunya, 08034 Barcelona (ES)
(72) Inventor: CASTAÑER MUÑOZ,Luis, E-08034 Barcelona (ES); LUQUE LÓPEZ, Antonio, E-28040 Madrid (ES); MARTÍ VEGA, Antonio, E-28040 Madrid (ES)
(74) Representative: ABG Patentes, S.L.
(86) International application number: PCT/ES2009/000038
(87) International publication number: WO 2009/106654

(57) **Abstract**

This invention describe a process for obtaining thin films of intermediate band semiconductor materials consisting of obtaining a target of compressed particles of the said material for its use in sputtering equipment. The target is obtained by means of the thermal process of a mixture of semiconductor material components, following a specific profile of temperatures and times, in order to obtain a material in a polycrystalline form of the same composition as the intermediate band semiconductor material. The polycrystalline material is disintegrated again by means of mechanical processes in the form of a powder and is then compacted, through the application of a suitable pressure in order to form a target.

## Description

### Field of the invention

Energy technology (photovoltaic converters), optical technology (LEDs and lasers), telecommunications and medical engineering (radiation sensors), laboratory instrumentation (photodetectors).

### Prior art

The "intermediate-band materials" make up the basis of a new generation of photovoltaic devices known as "intermediate-band solar cells" (IBSC). This new type of solar cell was patented in 2001 (US Patent 6444897B1) although at the time no ideas were put forward as to how these intermediate-band materials can be obtained, with the exception of its synthesis by means of quantum dot technology.

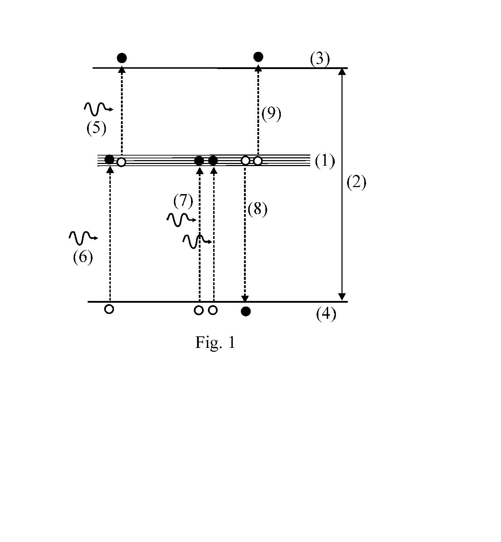

An intermediate-band material is characterized as exhibiting a collection of permitted levels (1) for the electrons in the interior of what would be in another form the prohibited band (2) of a semiconductor (Fig. 1). In order to refer to this collection of intermediate levels the term "band" is preferred. The aim is to emphasize a series of physical properties which are required for this collection and which are more characteristics of the electronic bands of the semiconductors than the levels that the defects can also introduce into the gap of a semiconductor. Thus, for example, it is necessary for these levels to make the absorption of photons possible, as will be explained later, as well as that in an ideal case, the recombination processes from the conduction band (3) to the intermediate band (1) and from the intermediate band (1) to the valence band (4) are radiatively limited (that is, by processes, that emit a photon). The general fundamentals of this theory were published in 1997 by Luque and Marti (A. Luque y A. Marti, Physical Review Letters 78, 5014-5017, 1997).

The existence of the intermediate band is beneficial for the functioning of a solar cell because it allows two energy photons to be absorbed below the gap, which in another form would be lost as the semiconductor is transparent to them, in order to generate an electron-hole pair. It is also possible that this additional absorption of photons takes place without a degradation of the output voltage of the cell.

The generation of this electron-hole pair takes place because, for example, a photon (5) pumps an electron from the valence band to the intermediate band and another (6) from the intermediate band to the conduction band. The general theory of the intermediate band solar cell points out that for this type of mechanism to be efficient, the intermediate band must be found partially full of electrons with the aim of having enough empty states to receive electrons from the valence band, as occupied states, to be able to supply electrons to the conduction band. On the other hand, for the next generation of an electron-hole pair it would also be possible that two photons are absorbed (7) by means of two transitions from the valence band to the intermediate band. After that, an electron (8) in the intermediate band would be recombined with a hole in the valence band through an ionization by impact process which would give rise to the pumping of a second electron (9) from the intermediate band to the conduction band (A. Luque et al., IEEE Transactions on Electron Devices 50, 447-454, 2003).

It has been calculated that the photovoltaic conversion efficiency limit for this new type of solar cell is 63.2% (A. Luque y A. Marti, Progress in Photovoltaics: Res. Appl. 9, 73-86, 2001). Interest in IBSC does not only lie in its high efficiency limit, even higher than that of tandem of two solar cells in series, but also as it bases its operation on a physical principle which opens the door to a new type of materials - the intermediate band materials - whose use could finally give rise to a production cost of photovoltaic kWh competitive with that produced from other sources of energy.

The use of quantum dots has been proposed for the synthesis of intermediate band materials (A. Marti et al. Proc. of the 28th IEEE Photovoltaics Specialists Conference, edited by IEEE, New York, 2000). In fact, IBSC prototypes based on quantum dots have recently been manufactured which has allowed the functioning principles of the intermediate-band solar cell to be demonstrated experimentally (A. Luque et al., Applied Physics Letters 87, 083505-3, 2005; A. Marti et al., Physical Review Letters 97, 247701-4, 2006). However, the use of quantum dots carried out in these works is based on semiconductor heterostructures that use III-V compounds. Consequently, the manufacturing cost of the cell continues to be in the same order of magnitude as that of a multiunion cell, which is why a reduction in the price of photovoltaic kWh by means of quantum dots can only be achieved through the real attainment of devices with efficiencies significantly higher than that of multiunion cells.

The literature theoretically predicts the existence of several materials which exhibit this intermediate band as one of its inherent characteristics. It is the case, for example, of the CuGaS₂ with 25% of Ga substituted by Ti (P. Palacios et al. Physica Status Solidi a-Applications and Materials Science 203, 1395-1401, 2006), del TiₓGa₁₋ₓP (P. Palacios et al. Physical Review B 73, 2006), of the ZnS doped with Cr (C. Tablero, Physical Review B 74, 2006). On the other hand, Yu et al. found experimental evidence of the formation of multiple bands in II-VI semiconductors with diluted oxygen (Yu et al. Physical Review Letters 91, 246403, 2003) and in quaternary compounds of GaNAsP (K. M. Yu et al. Applied Physics Letters 88, 092110, 2006). In a more general context, it has been defended that a sufficiently high concentration of impurities (higher than the value that defines the Mott transition) would be enough to give rise to deep centers that inhibit the non-radiative recombination mechanisms typically associated to these levels and go on to reveal intermediate band properties (Parent Application P200503055; A. Luque et al. Physica B 382, 320-327, 2006).

However, in none of these cases is the process described in this patent described as a method to synthesize an intermediate band material, which is also applicable in general to several types of material. This process will be detailed in the following section.

### Description of the invention

In order to explain how our invention permits the practical obtaining of semiconductor materials incorporating an intermediate band, it is necessary to refer to the metallurgy of materials in the form of particles known as '*powder metallurgy*' which, having being known about for more than a hundred years, has been used industrially for the past 25 years to produce mechanical components using metallic powders and heating them to just below their melting point. A processing method known as '*press and sinter*' stands out from amongst the other more common ways of processing these pieces. It consists of placing the powder of the material in a mould and compacting it at a certain pressure so that it can then be extracted from the mould. It then goes on to be treated thermally in a controlled atmosphere. There are other methods related to this technique as for example the application of pressure and heat simultaneously, the forging of the preforms after pressed or the injection.

However, the majority of the industrial solutions and methods are directed towards achieving the manufacture of pieces with cheaper processes and with little need for their later mechanization in order to achieve the required tolerances and dimensions. These motivations do not exist in the objective of this patent, in that it is a process that, although it is related to the metallurgy of materials in the form of particles, it has the characteristics described below and which also allows it to be distinguished from the metallurgy of conventional powder:
This invention refers to a process for the obtaining of thin films of semiconductor materials with an intermediate band and not the making of pieces with this material. The obtaining of the aforementioned thin films is carried out in the following steps:
   - Preparation of the mixture of the components of the semiconductor material in the form of powder, by means of the selection of the ratios necessary for the mixture to be stoichiometric, but without excluding other proportions
   - Thermal processing of the mixture of the components of the semiconductor material obtained in the previous step higher than the melting point of its components until its synthesis in the form of thermodynamically stable polycrystalline semiconductor material. It is not necessary to use the mould in this part of the processing as the form of the material resulting from the thermal processing is not important for the rest of the process.
   - Once the semiconductor material has been achieved in accordance with that described in the previous step, it will take the shape of the support that has been used. One possibility, without discounting the other ways of supporting the material during the thermal process, is to enclose the mixture of components of the semiconductor material in a quartz ampoule sealed in a vacuum, in such a way that it avoids the contamination of the mixture at a high temperature. Consequently, in a way similar to the metallurgy of conventional powder, in this invention the atmosphere in which the thermal process takes place is controlled. It could be in a vacuum without discounting any other atmosphere. However, unlike the metallurgical process of conventional powder, the thermal treatment is done directly on the powder of the stoichiometric mixture without it having previously undergone the molding process under pressure.

- Disintegration of the polycrystalline material obtained through the previous step by means of its mechanical grinding until a homogeneous powder is obtained, which is now a powder of intermediate band semiconductor material instead of a mixture of powders of their components.
- Compressing of the homogeneous powder until it has a consistency and form suitable for its placing on an electrode of the sputtering machine. The simplest, without excluding other ways, consists of the shape of a tablet of a diameter and thickness suitable for the electrode of the sputtering machine.
- Obtaining thin films of intermediate band semiconductor material by means of the sputtering of the compressed powder.

### Description of the drawing

**Figure 1****.** Simplified band diagram of an intermediate band solar cell showing the intermediate band (1), the conduction band (3), the valence band (4), the total bandgap (2), the absorption process of a photon from the valence band to the intermediate band (6), from the intermediate band to the conduction band (5) and an example of generation by impact ionization through which the absorption of two low-energy photons (7) gives rise again to the net promotion of an electron from the intermediate band to the conduction band (9) after capturing the energy of one of the electrons (8) when recombining from the intermediate band to the valence band.

### Preferred method of manufacturing

The compound chosen for the description of this preferred method of manufacturing, Ga_{0.99}AsTi_{0.01}, is a typical semiconductor compound that might have an intermediate band, without excluding other compounds or compositions. The preferred method of manufacturing consists of several steps: (a) preparation and weight of the materials; (b) making the target for sputtering and (c) depositing the fine layers of the compound material by means of sputtering.

The step (a) preparation and weight of the materials consists of obtaining the materials gallium, arsenic and titanium. Gallium is a material that is acquired in the form of 100g minimum ingots of 99.999% purity and is usually supplied in dry ice since it has a melting point of 29.78°C. The arsenic is supplied in crystalline form. The titanium is supplied in powder form with particles of 20 microns with a purity of 99.7%.

The preparation of the materials consists of weighing the suitable proportions in order to obtain a stoichiometric mixture with the proportions of the compound. For 100 grams of compound, this mixture consists of, 47.791 gr. of gallium, 51.877 gr. of arsenic and 0.332 gr. of titanium.

Once the amounts of the elements gallium, arsenic and titanium necessary are available, they are then mixed together cold. After that, the metallurgic process necessary to achieve the compound material is carried out. This process consists of the introduction of the compound materials into a quartz ampoule duly sealed at one of its extremes. The gases present in the ampoule are evacuated and it is then filled with Argon at a pressure of 10⁻³ Torr in order to avoid unwanted reactions in the component elements with the oxygen and nitrogen in the air. Once the argon pressure necessary is achieved, the quartz ampoule is sealed at the other end. It then goes on to carry out a thermal cycle higher than the melting temperature of the three elements with slow increase and decrease temperature slopes, usually in the order of 10°C per hour, without excluding other speeds. After this thermal cycle the crystallization of the compound with a suitable composition is achieved if the phase is stable. The result of this phase is a polycrystalline ingot of the desired composition.

The step (b) of the detailed manufacturing process consists of the grinding of the polycrystalline ingot into fine particles in the order of 20 microns without excluding other sizes. Having achieved thus the powder of the compound with the desired composition, it is then introduced into a capsule, which undergoes pressure, usually of several atmospheres and at ambient temperature, without excluding other pressures or temperatures. The result of this step is a pressed capsule of the composed material with the desired stoichiometry.

The step (c) of the preferred manufacturing process consists of the introduction of the aforementioned capsule into the support of the targets in a sputtering system, usually refrigerated. The vacuum cabin is then closed and the parameters of the deposit are adjusted. The parameters are the radiofrequency power and the pressure of the argon in the chamber in accordance with the manufacturer's instructions, without excluding other conditions. The time necessary depends on the thickness of the film that is deposited, which will usually be of several microns, without excluding other thicknesses.

## Claims

1. Procedure for obtaining films of intermediate band semiconductor materials **characterized in that** it comprises the following steps:
- preparation of the mixture of the components of the semiconductor material in the form of a powder,
- thermal processing of the mixture of the components of the semiconductor material obtained in the previous stephigher than the melting point of its components up to its synthesis in the form of a thermodynamically stable polycrystalline semiconductor material,
- disintegration of the polycrystalline material obtained in the previous step by means of mechanical grinding until a homogeneous powder is obtained,
- compressing of the homogenous powder until it has a consistency and shape suitable for its placing onto an electrode of a sputtering machine,
- Obtaining the thin films of intermediate band semiconductor material by means of the sputtering of the compressed powder.

2. Procedure in accordance with demandaccording to claim 1 **characterized** becausein that, in a preferred method, the semiconductor material consists of a stoichiometric mixture of its components.

3. Procedure in accordance with demandsaccording to claim 1 or claim 2 **characterized** becausein that, in a preferred method, before the thermal processing, the mixture of the semiconductor material is introduced into a recipient container in which there is a controlled atmosphere in order to avoid the contamination of the mixture at high temperatures.
